Europäisches Patentamt

European Patent Office

Office européen des brevets

(11) Publication number: **0 111 706**
**B1**

# EUROPEAN PATENT SPECIFICATION

(45) Date of publication of patent specification: **11.03.87**

(51) Int. Cl.⁴: **H 01 L 29/60,** H 01 L 21/28

(21) Application number: **83110954.1**

(22) Date of filing: **03.11.83**

(54) Sidewall isolation for gate of field effect transistor and process for the formation thereof.

(30) Priority: **07.12.82 US 447543**

(43) Date of publication of application:
**27.06.84 Bulletin 84/26**

(45) Publication of the grant of the patent:
**11.03.87 Bulletin 87/11**

(84) Designated Contracting States:
**DE FR GB**

(56) References cited:
**EP-A-0 036 573**
**GB-A-2 074 374**
**US-A-4 074 300**
**US-A-4 330 931**

**IBM TECHNICAL DISCLOSURE BULLETIN,
volume 24, no. 1A, June 1981 (NEW YORK, US)
C.G. JAMBOTKAR "Fet structure", pages 57-60**

**IBM TECHNICAL DISCLOSURE BULLETIN,
volume 22, no. 8A, January 1980 (NEW YORK,
US) W.P. DUMKE et al. "High density JFET",
pages 3415-3417**

(73) Proprietor: **International Business Machines
Corporation
Old Orchard Road
Armonk, N.Y. 10504 (US)**

(72) Inventor: **Iyer, Subramanian Srikanteswara
60 Barker Street No. 414 Mt. Kisco
New York 10549 (US)**

(74) Representative: **Hobbs, Francis John
IBM United Kingdom Limited
Intellectual Property Department
Hursley Park
Winchester Hampshire SO21 2JN (GB)**

## Description

This invention relates to sidewall isolation of the gate in a field effect transistor.

Electrical connections to the source, drain, and gate regions of a field effect transistor can be achieved by various processes. One such procedure involves the reaction of a metal such as titanium, cobalt, palladium, or nickel with exposed silicon to obtain self-aligned contacts to the source, drain, and gate regions of the device. Achieving self-alignment is significant in the fabrication of field effect transistors since one of the most crucial steps in preparing FET devices is a lithographic masking step which requires high precision in registration (i.e., relative mask-to-mask alignment) and extreme care in execution.

In following the above procedure for achieving self-alignment of metallic type contacts to the source, drain, and gate regions of a FET device, it is important to maintain the electrical isolation of the gate from the source and drain regions. This is accomplished by providing an isolation or electrical insulation layer on the sidewalls of the gate (which can be referred to as "spacer") and between the gate and semiconductor substrate. To obtain self-aligned contacts, a metal is deposited over the entire region (the source, drain, gate, and over the sidewall isolation between the gate and the source and drain regions). Subsequent to this, the metal is reacted with the available exposed silicon which it contacts to form a metallic silicide. Since the sidewalls are of an isolation material such as an oxide or nitride, reaction between the metal and the sidewall should not occur to form silicide. Subsequent to this, the unreacted metal on the sidewall isolation can then be selectively etched away.

However, it has been observed in attempting to prepare devices by the procedure discussed above, that although free silicon is not present on the sidewalls, nonetheless, metallic silicides have formed thereon. This, in turn, causes electrical leakage between the source, drain, and gate areas across the spacer paths. It is not entirely understood as to what causes the silicide formation on the sidewall, but it is believed that possibly silicon is diffused through the metal on the sidewall due to the temperature of the silicide formation and this leads to silicide formation there. This is particularly noticeable when employing metals such as cobalt and titanium to form the silicide.

In order to prevent possible diffusion paths on the silicon over the spacer and thereby eliminating electrical leakage across the space, the invention provides a recess in the sidewall isolation so that a discontinuous metal film is obtained over the sidewall isolation layer rather than a continuous metal film as is obtained in accordance with the above discussed technique.

Providing a discontinuous film over the sidewall isolation spacer prevents the formation of a continuous silicon diffusion path over the spacer. This prevents the formation of a continuous silicide film over the spacer and thereby precludes electrical leakage across the spacer after the unreacted metal has been selectively etched away.

The article in pages 57 to 60 of the IBM Technical Disclosure Bulletin Volume 24, no 1A, June 1981, discloses an FET structure in which an N+ polysilicon gate is provided with a composite layer of silicon nitride/silicon dioxide on its sidewall.

A field effect transistor structure including a gate provided with first and second layers of insulating materials on its sidewalls, the first and second layers being of materials which etch at different rates in a predetermined etchant, is characterised, according to one aspect of the invention, by there being a recess etched in the side of one of the first and second layers, the recess preventing the formation of a continuous metal film on the sidewalls when metal is subsequently deposited over the structure.

A process for forming a field effect transistor structure including forming first and second layers of insulating materials on the sidewall of a gate, the first and second layers being of materials which etch at different rates in a predetermined etchant, is characterised, according to another aspect of the invention, by forming a recess in the side of one of the first and second layers, the recess preventing the formation of a continuous metal film on the sidewalls when metal is subsequently deposited over the structure.

Although the present invention can be practised with only two layers, it is preferred to provide a third, outer insulating layer. The third insulating layer, if provided, can have substantially the same or a different etch rate as does the second insulating layer or the first insulating layer. However, it is preferred that such a third layer have an etch rate substantially the same as that of the first electrical insulating layer. The layers are then etched whereby the second layer is etched at a rate different from the first layer to thereby provide recesses in the sidewall isolation. Preferably the second layer is etched at a rate faster than the first layer and third layer, if present, resulting in a recess below the surface level of the first and third layers.

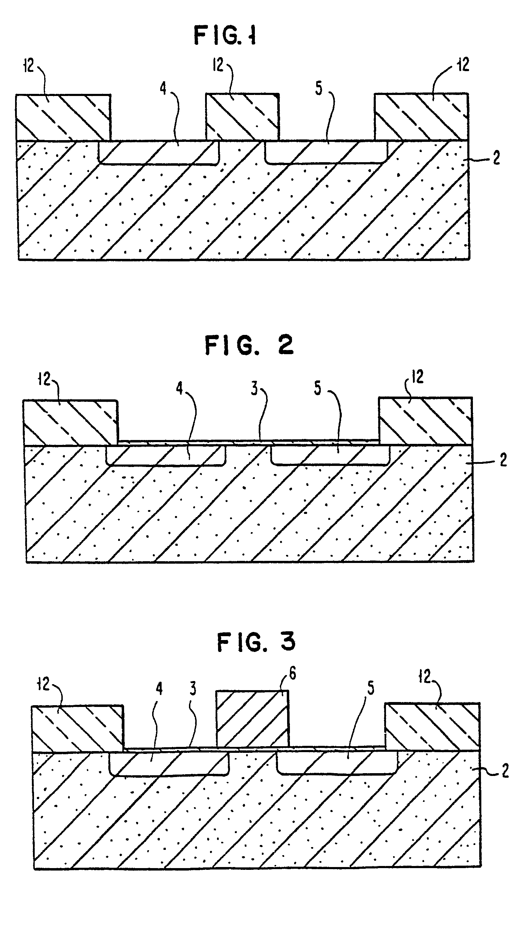

How the invention can be carried out will now be described by way of example, with reference to the accompanying drawings, in which Figures 1 to 8 represent the cross-section of a simplified field effect transistor structure at successive stages in a process of forming it in accordance with the invention.

For convenience, the discussion of the fabrication steps is directed to the preferred aspect of employing a p-type silicon substrate as the semiconductive substrate and n-type impurities. This leads to the n-channel FET technology. Alternatively, an n-type substrate and a p-type diffused or implanted dopant impurity can be employed according to the present invention in p-channel FET technology.

When reference is made to impurities of the "first type" and to impurities of a "second type", the "second type" is of opposite conductivity to the "first type". That is, if the "first type" is p, then the "second type" is n. If the "first type" is n, then the "second type" is p.

Although the fabrication process is described employing the preferred material, polycrystalline silicon, for the gate other suitable materials can be employed.

A p-type silicon substrate 2 (Figure 1) has any desired crystal orientation (e.g., <100>) and can be prepared by slicing and polishing a p-type boule grown in the presence of a p-type dopant, such as boron following conventional crystal growth techniques. Other p-type dopants for silicon include aluminium, gallium, and indium.

Field oxide isolation 12 can be fabricated by any of the several known procedures including thermal oxidation of the semiconductor substrate or by well known vacuum vapor deposition techniques. Furthermore, the field oxide may be formed above the semiconductor surface or it may be partially or fully recessed into the semiconductor substrate. An example of one such procedure is the fully recessed oxide isolation technique disclosed in US—A—3,899,363.

For the purposes of illustration of the procedure of the present invention, a non-recessed field isolation oxide 12 will be used. The field isolation regions are generally about 4,000 to about 10,000 angstroms (1 Å = 0.1 nm) thick. The field oxide regions 12 and the regions under which source and drain regions 4 and 5 are formed are delineated by employing a lithographic mask. The mask is of a transparent material having opaque portions in a predetermined pattern. Next, source and drain regions 4 and 5 are formed in the p-silicon substrate 2, such as by thermal diffusion or ion-implantation of an impurity of the n-type. Examples of some n-type impurities for silicon substrates include arsenic, phosphorus, and antimony.

The field oxide 12 using a photolithographic technique is etched from that area where a thin gate oxide insulator layer 3 is to be subsequently grown.

A relatively thin gate insulator layer of silicon dioxide 3 (see Figure 2) is grown on or deposited onto the silicon substrate 2. This gate insulator, which is usually about 100 to about 1,000 angstroms thick, can be formed by thermal oxidation of the silicon substrate at about 800—1000°C in the presence of oxygen.

Next, the gate 6 of the FET is deposited and delineated by known photolithographic technique. The gate 6 of the FET is preferably of polycrystalline silicon and is generally doped to the same conductivity type as the source and drain.

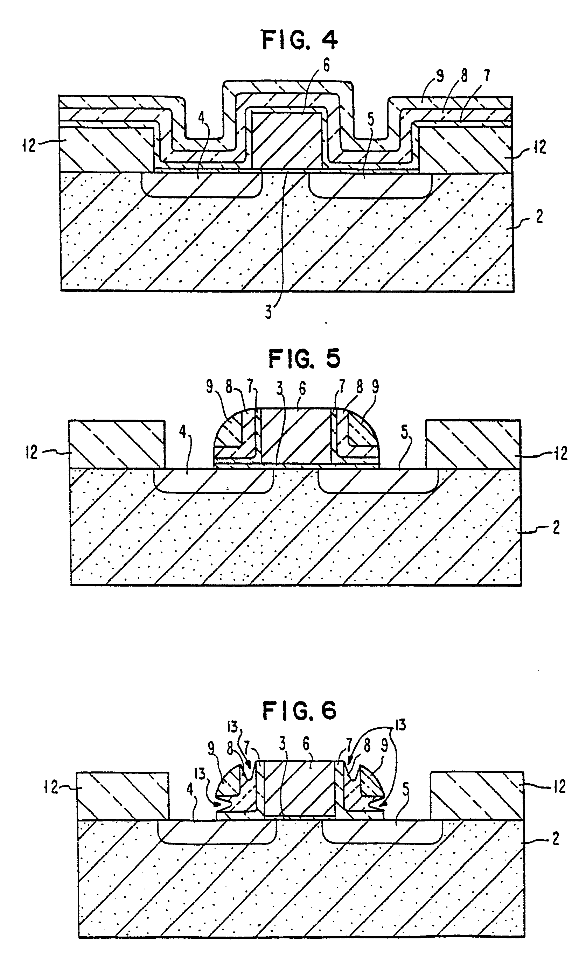

Next, a layer 7 of silicon dioxide is provided over the entire structure including the polycrystalline silicon gate 6 (see Figure 4). This silicon dioxide layer can be grown on or deposited on to the substrate and the gate 6. This layer is usually about 500 to about 1,500 angstroms thick and can be formed by thermal oxidation of the silicon surface and polycrystalline silicon surface at about 800—1000°C in the presence of oxygen.

Next, a layer 8 of an electrically insulating material, different from the silicon dioxide, is provided over the silicon dioxide. An example of such a material is silicon nitride. Other materials which can be used as layer 7 or layer 8 include oxides such as aluminium oxide and magnesium oxide.

The silicon nitride can be formed by chemical vapor deposition and is usually about 100 to 1,000 angstroms thick.

An additional layer 9 of silicon dioxide is then deposited. The silicon dioxide layer is approximately 500 to 1,500 angstroms thick and may be formed by chemical vapor deposition.

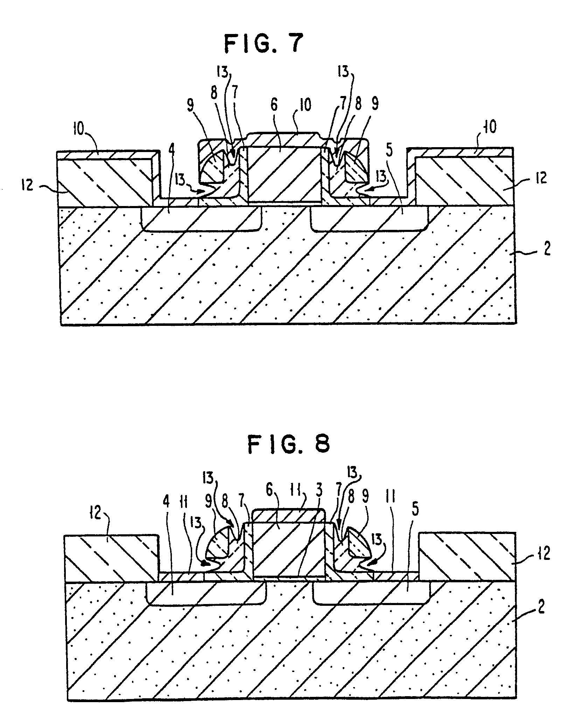

Through vertically directional reactive ion etching, silicon dioxide layer 7, silicon nitride layer 8, and silicon oxide layer 9 are etched so that the structure shown in Figure 5 is obtained. Since the rates of etching of the silicon oxide and silicon nitride employing reactive ion etching are substantially the same, no depressions or recesses are formed in the isolation structure employing the reactive ion etching technique. Typical conditions of reactive ion etching include using a $CF_4$ gas at about 25 microns of pressure at a gas flow rate of about 40 standard cubic centimeters per minute and employing about 20 watts of power, which is equivalent to a power density of about 0.073 watts per $cm^2$. These particular parameters provide for an etch rate of about 160 angstroms per minute.

The sidewall spacer so formed is about 2000 Å wide at the base. Also, in this process, the source and drain regions are exposed. Source and drain may be formed, for example, by ion-implantation of n-type dopant at this stage.

Next, the remaining silicon dioxide layer 7, silicon nitride layer 8, and silicon dioxide 9 are subjected to a chemical etch to thereby form recesses 13 in the sidewall isolation as illustrated in Figure 6. A typical etch employed is phosphoric acid solution at about 180°C. The silicon nitride is etched to a much greater extent than the silicon dioxide in the presence of the phosphoric acid. Accordingly, recesses are formed in the sidewall isolation as illustrated in Figure 6. The etching is carried out for about 2—10 minutes to cause a 200—1000 Å recess in the sidewall isolation.

Next, a metal layer 10, such as cobalt, titanium, nickel, or one of the platinum groups of metals is deposited over the structure such as by sputtering or preferably vapour deposition. The recesses 13 prevent a continuous metallic film from forming on the sidewalls of the gate, as illustrated in Figure 7.

Next, the metal is reacted with the silicon at elevated temperature such as about 400 to about 800°C to provide a metallic silicide 11. The preferred metals employed are cobalt and titanium. The temperatures employed for the cobalt and titanium are at least about 550°C, while those for the platinum group of metals are about 400 to about 500°C.

After formation of the silicide, the unreacted metal can be removed from the structure by etching with an etchant which will not affect the silicide, but will selectively remove the unreacted metal. For instance, with titanium, the etch employed can be a solution of 1:1:5 volume ratio of ammonium hydroxide, hydrogen peroxide, and water (see Figure 8).

**Claims**

1. A field effect transistor structure including a gate (6) provided with first and second layers (7, 8) of insulating materials on its sidewalls, the first and second layers being of materials which etch at different rates in a predetermined etchant, characterised by there being a recess (13) etched in the side of one of the first and second layers, the recess preventing the formation of a continuous metal film on the sidewalls when metal is subsequently deposited over the structure.

2. A structure as claimed in claim 1, in which there is a third, outer layer of insulating material on the sidewalls of the gate and in which the recess is formed in the second layer.

3. A structure as claimed in claim 2, in which the first and third layers are of the same material.

4. A structure as claimed in any preceding claim, in which the first layer is of silicon dioxide.

5. A structure as claimed in claim 4, in which the second layer is of silicon nitride.

6. A structure as claimed in any preceding claim, in which the gate is composed of conductive polysilicon.

7. A process for forming a field effect transistor structure including forming first and second layers of insulating materials on the sidewall of a gate, the first and second layers being of materials which etch at different rates in a predetermined etchant, characterised by forming a recess in the side of one of the first and second layers by application of the predetermined etchant to the layers, the recess preventing the formation of a continuous metal film on the sidewalls when metal is subsequently deposited over the structure.

8. A process as claimed in claim 7, further including forming a third, outer layer of insulating material on the sidewalls of the gate, and in which the recess is formed in the second layer.

9. A process as claimed in claim 8, in which the first and third layers are of the same material.

10. A process as claimed in any of claims 7 to 9, in which the first layer is of silcon dioxide.

11. A process as claimed in claim 10, in which the second layer is of silicon nitride.

12. A process as claimed in any of claims 7 to 11, in which the gate electrode is of conductive polysilicon, the process further including depositing a metallic layer over the field effect transistor structure and reacting the metallic layer with the semiconductor material including that of the gate electrode, with which it is contiguous.

13. A process as claimed in claim 12, in which the metallic layer is of titanium, cobalt, nickel or a metal of the platinum group.

**Patentansprüche**

1. Feldeffekt-Transistoraufbau mit einem Gate (6), welches auf seinen Seitenwänden mit einer ersten und zweiten Schicht (7, 8) aus isolierenden Materialien versehen ist, wobei die erste und zweite Schicht aus Materialien sind, welche in einem bestimmten Ätzmittel mit verschiedenen Geschwindigkeiten ätzen, dadurch gekennzeichnet, daß in die Seite einer der ersten und zweiten Schicht eine Ausnehmung (13) geätzt ist, wobei die Äusnehmung die Bildung eines kontinuierlichen Metallfilms auf den Seitenwänden verhindert, wenn nachfolgend Metall auf dem Aufbau abgeschieden wird.

2. Aufbau nach Anspruch 1, bei welchem eine dritte, äußere Schicht aus isolierendem Material auf den Seitenwänden des Gate vorhanden ist und bei welchem die Ausnehmung der zweiten Schicht ausgebildet ist.

3. Aufbau nach Anspruch 2, bei welchem die erste und die dritte Schicht aus dem gleichen Material sind.

4. Aufbau nach irgendeinem vorstehenden Anspruch, bei welchem die erste Schicht aus Siliziumdioxid ist.

5. Aufbau nach Anspruch 4, bei welchem die zweite Schicht aus Siliziumnitrid.

6. Aufbau nach irgendeinem vorstehenden Anspruch bei welchem das Gate aus leitfähigem Polysilizium besteht.

7. Verfahren zur Ausbildung eines Feldeffekt-Transistoraufbaus, welches das Ausbilden einer ersten und zweiten Schicht aus isolierenden Materialien auf den Seitenwänden eines Gate enthält, wobei die erste und zweite Schicht aus Materialien sind, welche in einem bestimmten Ätzmittel mit verschiedenen Geschwindigkeiten ätzen, gekennzeichnet durch das Ausbilden einer Ausnehmung in der Seite einer der ersten und zweiten Schicht durch Anwendung des bestimmten Ätzmittels auf den Schichten, wobei die Ausnehmung die Ausbildung eines kontinuierlichen Metallfilms auf den Seitenwänden verhindert, wenn Metall nachfolgend auf dem Aufbau abgeschieden wird.

8. Verfahren nach Anspruch 7, welches ferner das Ausbilden einer dritten, äußeren Schicht aus isolierendem material auf den Seitenwänden des Gate enthält, wobei die Ausnehmung in der zweiten Schicht ausgebildet wird.

9. Verfahren nach Anspruch 8, bei welchem die erste und dritte Schicht aus dem gleichen Material sind.

10. Verfahren nach irgendeinem der Ansprüche 7 bis 9, bei welchem die erste Schicht aus Siliziumdioxid ist.

11. Verfahren nach Anspruch 10, bei welchem die zweite Schicht aus Siliziumnitrit ist.

12. Verfahren nach irgendeinem der Ansprüche 7 bis 11, bei welchem die Gate-Elektrode aus leitfähigem Polysilizium ist, wobei das Verfahren ferner das Abscheiden einer metallischen Schicht auf dem Feldeffekt-Transistoraufbau und das Reagierenlassen der metallischen Schicht mit dem halbleitermaterial einschließlich demjenigen der Gate-Elektrode, an welches sie angrenzt, enthält.

13. Verfahren nach Anspruch 12, bei welchem die metallische Schicht aus Titan, Kobalt, Nickel oder einem Metall der Platingruppe ist.

## Revendications

1. Structure de transistor à effet de champ comportant une grille (6) formée avec une première et une seconde couche (7, 8) de matières isolantes sur ses parois latérales, la première et la seconde couche étant faite de matières qui sont décapées à des vitesses différentes dans un produit d'attaque prédéterminé; caractérisée en ce qu'elle comporte un logement (13) gravé dans le côté de l'une de la première et la seconde couche, le logement empêchant la formation d'une pellicule métallique continue sur les parois latérales lorsqu'un métal est ensuite déposé sur la structure.

2. Structure selon la revendication 1, qui comporte une troisième couche extérieure de matière isolante sur les parois latérales de la grille et dans laquelle le logement est formé dans la seconde couche.

3. Structure selon la revendication 2, dans laquelle la première et la troisième couche sont faites de la même matière.

4. Structure selon l'une quelconque des revendications précédentes, dans laquelle la première couche est en bioxyde de silicium.

5. Structure selon la revendication 4, dans laquelle la seconde couche est en nitrure de silicium.

6. Structure selon l'une quelconque des revendications précédentes, dans laquelle la grille est faite de polysilicium conducteur.

7. Procédé de formation d'une structure de transistor à effet de champ consistant à former une première et une seconde couche de matières isolantes sur la paroi latérale d'une grille, la première et la seconde couche étant faites de matières qui sont décapées à des vitesses différentes dans un produit d'attaque prédéterminé, caractérisé en ce qu'il consiste à former un logement dans le côté de l'une de la première et la seconde couche par application du produit d'attaque prédéterminé aux couches, le logement empechant la formation d'une pellicule métallique continue sur les parois latérales lorsqu'un métal est ensuite déposé sur la structure.

8. Procédé selon la revendication 7, consistant en outre à former une troisième couche extérieure de matière isolante sur les parois latérales de la grille et dans lequel le logement est formé dans la seconde couche.

9. Procédé selon la revendication 8, dans lequel la première et la troisième couches sont faites de la même matière.

10. Procédé selon l'une quelconque des revendications 7 à 9, dans lequel la première couche est en bioxyde de silicium.

11. Procédé selon la revendication 10, dans lequel la seconde couche est en nitrure de silicium.

12. Procédé selon l'une quelconque des revendications 7 à 11, dans lequel l'électrode de grille est en polysilicium conducteur, le procédé consistant en outre à déposer une couche métallique sur la structure de transistor à effet de champ et à faire réagir la couche métallique avec la matière semi-conductrice, y compris celle de l'électrode de grille avec laquelle elle est contiguë.

13. Procédé selon la revendication 12, dans lequel la couche métallique est faite de titane, de cobalt, de nickel ou d'un métal du groupe du platine.

## FIG. 1

## FIG. 2

## FIG. 3

## FIG. 4

## FIG. 5

## FIG. 6

## FIG. 7

## FIG. 8